# EUROPEAN PATENT APPLICATION

(11) **EP 4 546 416 A1**
(43) Date of publication of application: **30.04.2025**
(21) Application number: 24186181.4
(22) Date of filing: 03.07.2024
(51) Int. Cl.: H01L 23/522

(54) **LOW RESISTANCE PLANAR CAPACITORS**

(30) Priority: 25.10.2023 US 202318383714
(71) Applicant: INTEL Corporation, Santa Clara, CA 95054 (US)
(72) Inventor: KANTHI, Basavaraj, 560100 Bengaluru (IN); COLLINS, Andrew P., Chandler, 85249 (US); XIE, Jian Yong, Chandler, 85226 (US)
(74) Representative: Goddar, Heinz J.

(57) **Abstract**

Embodiments disclosed herein include a capacitor apparatus (330). In an embodiment, the apparatus comprises a first metal layer (331, 331A, 331B) and a first plate (335A) above the first metal layer, where the first plate is electrically conductive. In an embodiment, a second plate (335B) is above the first plate, where the second plate is electrically conductive, and a third plate (335C) is above the second plate, where the third plate is electrically conductive. In an embodiment, a second metal layer (332, 332A, 332B) is above the third plate, and a first via (337) is between the first metal layer and the second metal layer, where the first via contacts the first plate and the third plate. In an embodiment, a second via (338) is between the first metal layer and the second metal layer, where the second via contacts the second plate, and a third via (339) is between the first metal layer and the first plate.

## Description

### BACKGROUND

Capacitors help reduce voltage droop and improve power delivery performance of integrated circuit designs. The effective resistance and capacitance of a capacitor plays a crucial role in the effectiveness of the capacitor. The rapid scaling of external deep trench capacitor based high frequency decap solutions has increased the need to improve the capacitor performance for die side planar capacitors, such as metalinsulator-metal (MiM) capacitors. MiM capacitors include a first metal layer and a second metal layer over the first metal layer. One or more electrically conductive plates may be provided between the first metal layer and the second metal layer. A high-k dielectric material may surround the stack of conductive plates. Vias between the first metal layer and the second metal layer are used to contact the plates. Since the capacitor structure includes substantially parallel plate structures, the capacitor structure may be referred to as being a planar capacitor.

One issue for existing planar capacitor structures is that the impedance is relatively high. This is due, at least in part, to the restriction of current flow from the electrically conductive plates into the overlying or underlying metal layers. Particularly, the only electrical path that is provided to the metal layers is through the vias that pass between the two metal layers. Increasing the diameter or number of vias may allow for a decrease in impedance. However, increasing the footprint of the vias will reduce the area available to generate capacitance. That is, there is a tradeoff between capacitance density and impedance.

### BRIEF DESCRIPTION OF THE DRAWINGS

Figure 1A is a cross-sectional illustration of a die with a semiconductor substrate and a dielectric stack that includes a capacitor structure, in accordance with an embodiment.
Figure 1B is a perspective view illustration of metal layers and plates in a capacitor structure, in accordance with an embodiment.
Figure 2A is a cross-sectional illustration of a capacitor structure with a via connecting a first plate and a third plate to the metal layers, in accordance with an embodiment.
Figure 2B is a cross-sectional illustration of a capacitor structure with a via connecting a second plate to the metal layers, in accordance with an embodiment.
Figure 3 is a cross-sectional illustration of a capacitor structure with a first via, a second via, and third vias providing additional electrical routing paths, in accordance with an embodiment.
Figure 4 is a perspective view illustration of a portion of a capacitor structure, in accordance with an embodiment.
Figures 5A - 5J are cross-sectional illustrations depicting a process for forming a capacitor structure, in accordance with an embodiment.
Figure 6A is a cross-sectional illustration of a capacitor structure with additional vias connecting the top metal layer to a third plate, in accordance with an embodiment.
Figure 6B is a cross-sectional illustration of a capacitor structure with an additional via connecting the first plate and the third plate to the bottom metal layer, in accordance with an embodiment.
Figure 7A is a cross-sectional illustration of a capacitor structure with additional vias connecting metal layers to plates within the plate stack, in accordance with an embodiment.
Figure 7B is a cross-sectional illustration of a capacitor structure with additional vias coupling metal layers to plates within the plate stack, in accordance with an additional embodiment.
Figure 8 is a cross-sectional illustration of an electronic system with a die that includes a capacitor structure, in accordance with an embodiment.
Figure 9 is a schematic of a computing device built in accordance with an embodiment.

### EMBODIMENTS OF THE PRESENT DISCLOSURE

Described herein are electronic systems, and more particularly, die side capacitors with additional vias to reduce resistance, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

As noted above, capacitor structures in die side structures can be used to improve electrical performance of an electronic system. Particularly, capacitors can help reduce voltage droop and improve power delivery performance of integrated circuit designs. However, in high frequency applications, capacitor impedance can be a limiting factor in the performance of the capacitor. Unfortunately, existing solutions for decreasing impedance result in a decrease in the capacitance density of the capacitor structure. For example, increasing the number or diameter of the vias reduces the space available for capacitive plates. Accordingly, there is an existing tradeoff that needs to be balanced in order to provide a desired performance.

As such, embodiments disclosed herein include capacitor structures that include additional vias without impacting the capacitance density. This is enabled through the use of vias that do not pass through the thickness of the electrically conductive plates between the metal layers. Since no openings are formed through the plates, their capacitance density is not impacted. Further, the additional vias may be located along the existing traces of the metal layers. This allows for the addition of vias without impacting any routing designs, and integration of such embodiments is simplified.

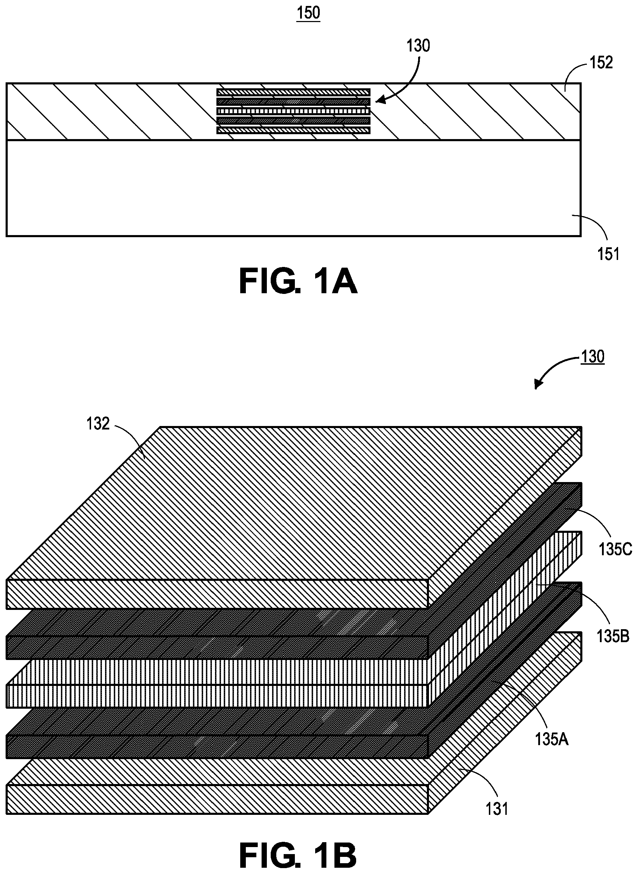

Referring now to Figure 1A, a cross-sectional illustration of a die 150 is shown, in accordance with an embodiment. The die 150 may be any type of die 150, such as a central processing unit (CPU), a graphics processing unit (GPU), an XPU, a communications die, a memory die, or the like. In some embodiments, the die 150 may also be a bridge die 150. A bridge die 150 may be suitable for communicatively coupling two or more overlying dies (not shown). A bridge die 150 may be entirely passive or a bridge die 150 may include active electrical components. The die 150 may also be an interposer structure. Similar to a bridge die 150, an interposer structure may be used to communicatively couple together two or more overlying dies (not shown).

In an embodiment, the die 150 may comprise a substrate 151. The substrate 151 may comprise a semiconductor material. For example, the substrate 151 may comprise silicon, a Group III-V semiconductor material, or the like. The substrate 151 may also comprise glass or a ceramic in some embodiments. The substrate 151 may comprise active electrical structures (not shown) such as transistor structures, or the like. That is, the substrate 151 may include regions of N-type or P-type doping, metallic contact structures, dielectric layers, or the like.

In an embodiment, a dielectric layer 152 may be provided over the substrate 151. The dielectric layer 152 may include electrical routing (not shown) to connect electrical structures on the substrate 151 to external components (such as a package substrate). The dielectric layer 152 may sometimes be referred to as the back-end-of-line (BEOL) stack. In an embodiment, the dielectric layer 152 may comprise passive electrical structures, such as resistors, capacitors, and the like. In a particular embodiment, the dielectric layer 152 may include one or more capacitor structures 130. In embodiments disclosed herein, the capacitor structure 130 may be a planar capacitor structure. The capacitor structure may include a first metal layer and a second metal layer, and a stack of electrically conductive plates may be provided between the first metal layer and the second metal layer.

Referring now to Figure 1B, a perspective view illustration of a portion of a capacitor structure 130 is shown, in accordance with an embodiment. As shown, the capacitor structure 130 comprises a first metal layer 131 and a second metal layer 132. The first metal layer 131 and the second metal layer 132 are shown as rectangular prisms for ease of illustration. However, the first metal layer 131 and the second metal layer 132 may comprise any number of electrically conductive traces that support different voltages (as will be described in greater detail below). The first metal layer 131 and the second metal layer 132 may comprise any suitable electrically conductive material, such as copper, an alloy of copper, or the like. Barrier layers, seed layers, and the like may also be included in the first metal layer 131 and the second metal layer 132.

In an embodiment, a stack of electrically conductive plates 135 may be provided between the first metal layer 131 and the second metal layer 132. In the embodiment shown, three plates 135A, 135B, and 135C are provided between the first metal layer 131 and the second metal layer 132. Though, embodiments may include one or more plates 135 in some embodiments. In the illustrated embodiment, the plates 135 have a thickness that is similar to a thickness of the metal layers 131 and 132. However, in other embodiments, thicknesses of the plates 135 may be smaller than thicknesses of the metal layers 131 and 132.

In the illustrated embodiment, the plates 135 are shown as being complete rectangular shapes. However, as will be described in greater detail below, the plates 135 may have openings in order to allow vias (not shown) to pass through one or more of the plates 135 without making electrical contact. The plates 135 in Figure 1B are shown with different shadings for clarity. In some embodiments, the plates 135A, 135B, and 135C may all comprise the same electrically conductive material, such as copper, an alloy of copper, or the like. The plates 135 may also have the same material composition as the first metal layer 131 and the second metal layer 132.

In the illustration of Figure 1B, the plates 135 are shown as "floating". It is to be appreciated that the plates 135 may be supported, surrounded, or embedded within a dielectric material. The dielectric material may be a high-k dielectric material in order to improve the capacitance of the capacitor structure 130. As used herein, a "high-k" dielectric material may include materials with a dielectric constant that is substantially equal to or higher than a dielectric constant of a material comprising silicon and oxygen, such as SiO₂. For example, high-k dielectric materials may comprise one or more of hafnium, lanthanum, zirconium, tantalum, titanium, barium, strontium, yttrium, lead, scandium, zinc, niobium, silicon, and oxygen. Examples of such materials include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

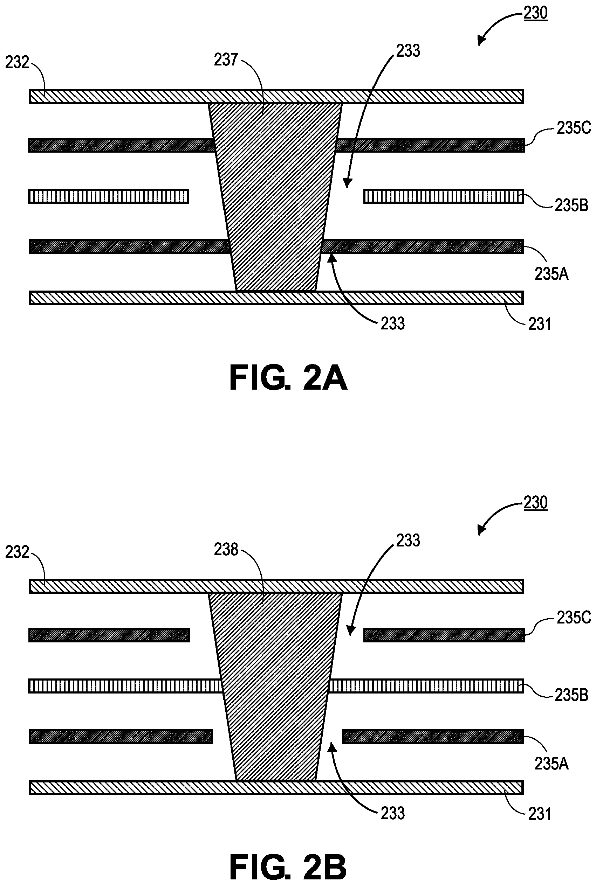

Referring now to Figure 2A, a cross-sectional illustration of a portion of a capacitor structure 230 is shown, in accordance with an embodiment. The capacitor structure 230 may comprise a first metal layer 231 and a second metal layer 232. A stack of electrically conductive plates 235 may be provided between the metal layers 231 and 232. In the illustrated embodiment, the stack includes three plates 235A, 235B, and 235C. The metal layers 231 and 232, and the plates 235 may be similar in structure and composition to those described in greater detail above.

In an embodiment, a via 237 may electrically couple the first metal layer 231 to the second metal layer 232. The via 237 may have a tapered shape, or the via 237 may have substantially vertical sidewalls. The via 237 may comprise copper, a copper alloy, or the like. Seed layers, barrier layers, and the like may also be provided as part of the via 237. In the illustrated embodiment, the via 237 may directly contact the first metal layer 231 and the second metal layer 232. In an embodiment, the via 237 may also be electrically coupled to one or more of the plates 235. For example, the first plate 235A and the third plate 235C are electrically coupled to the via 237. As such, the first plate 235A and the third plate 235C are maintained at a first voltage that is substantially the same voltage as the via 237.

In an embodiment, the second plate 235B is electrically isolated from the via 237. For example, an opening 233 is provided in the second plate 235B so that the via 237 can pass through the layer of the second plate 235B. The second plate 235B may maintain a second voltage that is different than the first voltage. As such, a capacitance is provided between the plates 235A, 235B, and 235C.

Referring now to Figure 2B, a cross-sectional illustration of a portion of a capacitor structure 230 is shown, in accordance with an additional embodiment. The capacitor structure 230 may comprise a first metal layer 231 and a second metal layer 232. A stack of electrically conductive plates 235 may be provided between the metal layers 231 and 232. In the illustrated embodiment, the stack includes three plates 235A, 235B, and 235C. The metal layers 231 and 232, and the plates 235 may be similar in structure and composition to those described in greater detail above.

As shown, a via 238 electrically couples the first metal layer 231 to the second metal layer 232. The via 238 may be substantially similar to the via 237 described in greater detail above. In an embodiment, the via 238 may contact the second plate 235B. As such, the second plate 235B is maintained at the second voltage that is substantially similar to the voltage of the via 238. The via 238 may pass through openings 233 in the first plate 235A and the third plate 235C. The first plate 235A and the third plate 235C may be contacted by a via 237 similar to the one shown in Figure 2A.

It is to be appreciated that the capacitor structures 230 in Figures 2A and 2B may be part of a single capacitor structure 230. This enables electrical coupling to the first plate 235A and the second plate 235C (Figure 2A) and to the second plate 235B (Figure 2B), while maintaining voltage differences between the plates. For example, the via 237 may be a Vcc (power) via 237, and the via 238 may be a Vss (ground) via 238. Further, the first metal layer 231 and the second metal layer 232 may have Vcc segments (Figure 2A), and the first metal layer 231 and the second metal layer 232 may have Vss segments (Figure 2B).

In Figures 2A and 2B, each of the plates 235 are contacted by a single via 237 or 238. This limits the amount of current that can flow to/from the metal layers 231 and 232 to the plates 235, and impedance is relatively high. As shown in Figures 2A and 2B, the vias 237 and 238 occupy space that could otherwise be used in order to increase capacitance in the capacitor structure 230. As such, the inclusion of additional vias 237 or 238 to reduce impedance is not ideal since it results in a decrease in capacitance. Accordingly, embodiments disclosed herein include alternative via architectures that allow for reduced impedance without sacrificing capacitance.

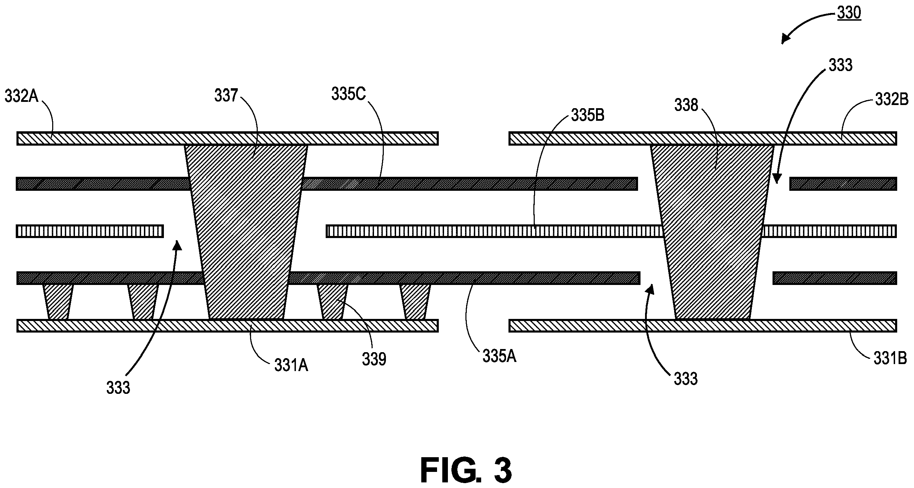

Referring now to Figure 3, a cross-sectional illustration of a capacitor structure 330 is shown, in accordance with an embodiment. In an embodiment, the capacitor structure 330 includes a first metal layer 331 and a second metal layer 332. The first metal layer 331 may be separated into a first region 331A at a first voltage and a second region 331B at a second voltage. Similarly, the second metal layer 332 may be separated into a first region 332A at the first voltage and a second region 332B at the second voltage. That is, within each metal layer 331 and 332, pads and traces that are held at different voltages may be provided. For example, first regions 331A and 332A may be at Vcc, and the second regions 331B and 332B may be at Vss.

In an embodiment, a stack of electrically conductive plates 335 may be provided between the first metal layer 331 and the second metal layer 332. In the illustrated embodiment, three plates 335A, 335B, and 335C are provided as one example, but the stack may include one or more plates 335 in other embodiments. The plates 335 may be electrically coupled to either of the voltage domains in order to generate capacitance between the plates 335. For example, plates 335A and 335C may be electrically coupled to the first regions 331A and 332A of the metal layers 331 and 332 by via 337, and plate 335B may be electrically coupled to the second regions 331B and 332B of the metal layers 331 and 332 by via 338.

In order to avoid contacting certain plates 335, the vias 337 and 338 may pass through openings 333 in the plates 335 where electrical contact is not desired. For example, via 337 passes through an opening 333 in the second plate 335B, and via 338 passes through openings 333 in the first plate 335A and the third plate 335C. More generally, the vias 337 and 338 may be configured so that they contact every other plate 335. For example, via 337 may contact odd number plates 335 (e.g., the first plate 335A, the third plate 335C, etc.), and via 338 may contact even number plates 335 (e.g., the second plate 335B, etc.).

In an embodiment, impedance can be reduced by providing additional electrical paths to one or more of the plates 335. For example, vias 339 are provided between the first region 331A of the first metal layer 331 and the first plate 335A. The vias 339 may be shorter than the vias 337 and 338. More particularly, the vias 339 may only pass between the first plate 335A and the first region 331A of the first metal layer 331. As such, there is no need for the vias 339 to pass through the thickness of any of the plates 335, and there is no need for additional openings. Since additional openings are not needed, there is no impact to the capacitance density of the capacitor structure 330. In the illustrated embodiment, four vias 339 are provided. Though, it is to be appreciated that one or more additional vias 339 may be provided in some embodiments.

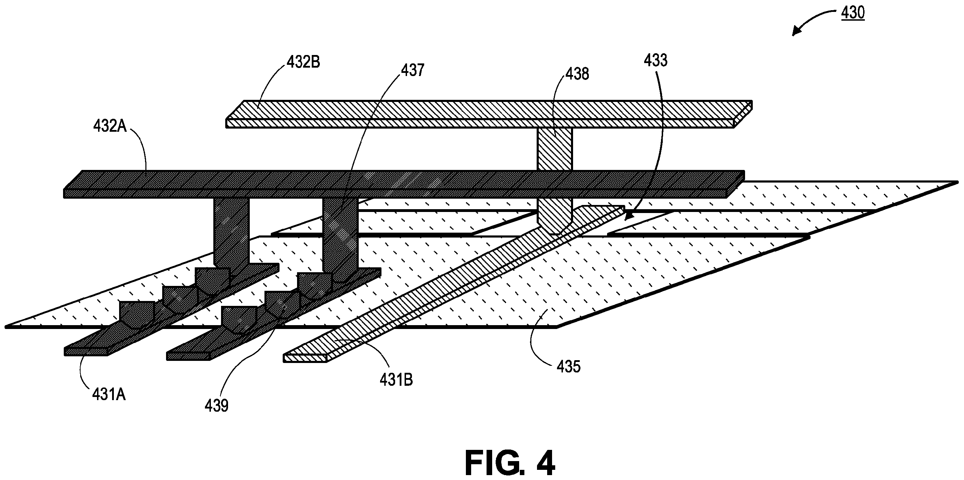

Referring now to Figure 4, a perspective view illustration of a portion of a capacitor structure 430 is shown, in accordance with an embodiment. In Figure 4, the first metal layer 431 and the second metal layer 432 are shown. For simplicity, only a first plate 435 is shown. Though, additional plates 435 may be provided between the first metal layer 431 and the second metal layer 432, similar to embodiments described in greater detail above.

As shown, the first metal layer 431 may comprise first traces 431A and a second trace 431B. The first traces 431A and the second trace 431B may be at the same level (in the Z-direction), but may be maintained at different voltages. At least some portions of the first traces 431A may run substantially parallel to at least some portions the second trace 431B. The second metal layer 432 may also comprise a first trace 432A and a second trace 432B. The first trace 432A may be at the same voltage as first traces 431A, and the second trace 432B may be at the same voltage as the second trace 431B. Portions of the traces 432A and 432B may have a length direction that is oriented substantially orthogonally to a length direction of portions of traces 431A and 432B.

In an embodiment, the first metal layer 431 may be electrically coupled to the second metal layer 432 through vias 437 and 438. For example, vias 437 electrically couple traces 431A to trace 432A, and via 438 electrically couples trace 431B to trace 432B. As shown, vias 437 pass through and contact the plate 435. In contrast, via 438 passes through an opening 433 in the plate 435. As such, via 438 is electrically isolated from the plate 435.

Additionally, vias 439 are provided between the plate 435 and the traces 431A of the first metal layer 431. The additional vias 439 reduce the impedance of the capacitor structure 430 and result in improved electrical performance. Further, it is to be appreciated that the vias 439 can be provided along existing lengths of the traces 431A that are needed for electrical routing. Accordingly, additional routing and/or pad formation is not necessary in order to implement additional vias 439. Since the vias 439 are provided along traces 431A, the vias 439 may be arranged in a linear pattern. The midline of the via 437 may also be along the line of the vias 439. That is, the vias 439 and the via 437 may positioned in a continuous line.

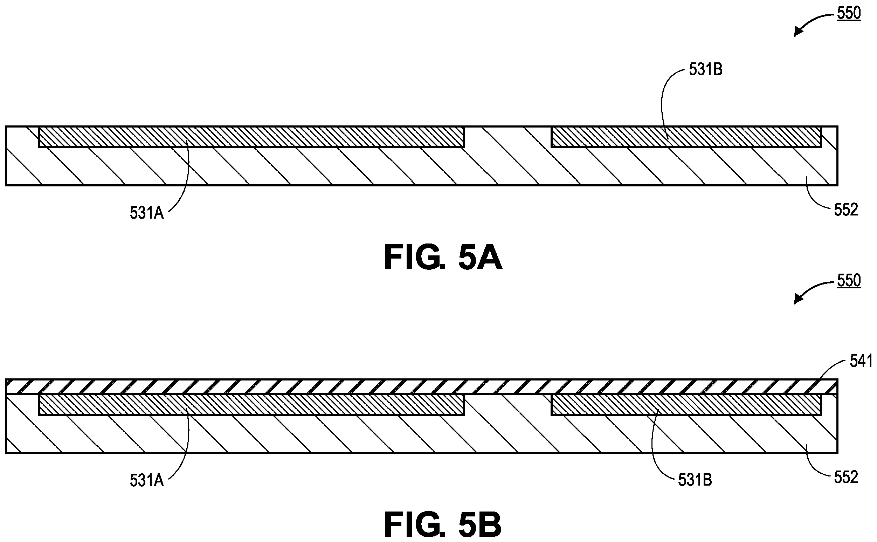

Referring now to Figures 5A - 5J, a series of cross-sectional illustrations depicting a process for forming a die 550 with a capacitor structure with improved impedance is shown, in accordance with an embodiment.

Referring now to Figure 5A, a cross-sectional illustration of a portion of a die 550 is shown, in accordance with an embodiment. In an embodiment, the die 550 may include a dielectric layer 552. The dielectric layer 552 may be part of a BEOL stack that is provided over an underlying substrate (not shown), such as a semiconductor substrate or the like. In an embodiment, the dielectric layer 552 may comprise silicon and oxygen (e.g., SiO₂) or any other suitable interlayer dielectric material.

In an embodiment, a first metal layer 531 may be provided in the dielectric layer 552. The first metal layer 531 may comprise traces, pads and the like. For example, a first trace 531A and a second trace 531B are shown. The first trace 531A and the second trace 531B may be configured to be held at different voltage potentials. For example, the first trace 531A may be held at Vcc and the second trace 531B may be held at Vss.

Referring now to Figure 5B, a cross-sectional illustration of the die 550 after an etchstop layer 541 is provided over a top surface of the first metal layer 531 is shown, in accordance with an embodiment. The etchstop layer 541 may be a material that is resistant to the etching chemistry used to form via openings in a subsequent processing operation. In some embodiments, the etchstop layer 541 may comprise silicon and nitrogen (e.g., Si₃N₄), silicon and carbon (e.g., SiC), or any other suitable material.

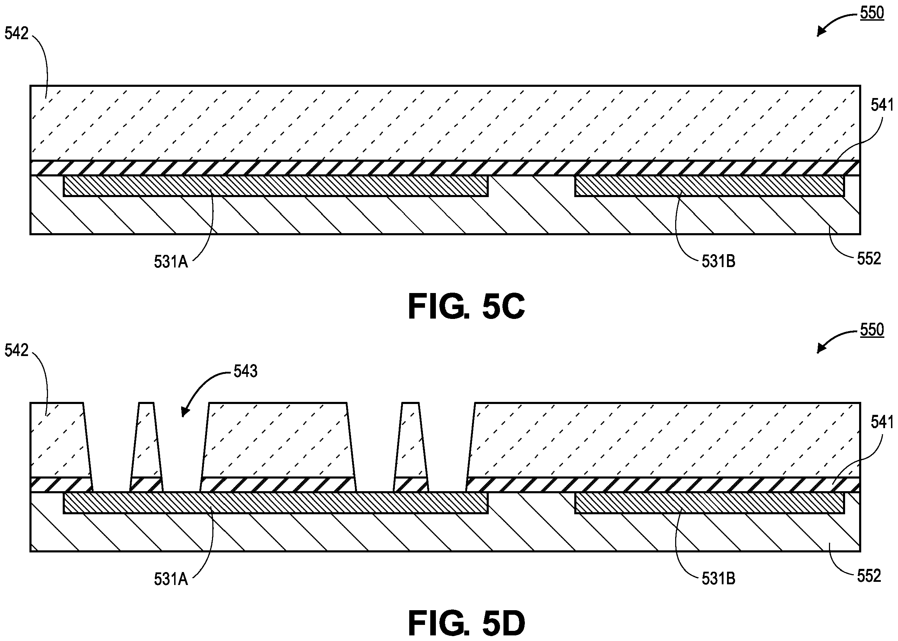

Referring now to Figure 5C, a cross-sectional illustration of the die 550 after an interlayer dielectric (ILD) 542 is applied over the etchstop layer 541 is shown, in accordance with an embodiment. The ILD 542 may comprise silicon and oxygen (e.g., SiO₂) or the like. In an embodiment, the ILD 542 may be applied with a chemical vapor deposition (CVD) process, physical vapor deposition (PVD) process, spin coating (e.g., spin-on dielectric (SOD)), or the like.

Referring now to Figure 5D, a cross-sectional illustration of the die 550 after via openings 543 are formed through the ILD 542 is shown, in accordance with an embodiment. In an embodiment, the via openings 543 may be positioned so that they land on the first trace 531A. The via openings 543 may pass through both the ILD 542 and the etchstop layer 541. In an embodiment, the via openings 543 may be formed with a lithography and etching process, or any other suitable subtractive process. The shape of the via openings 543 may depend on the process used to form the via openings 543. For example, with a lithographic process, via openings 543 with tapered sidewalls may be generated. In other embodiments, the via openings 543 may have substantially vertical sidewalls.

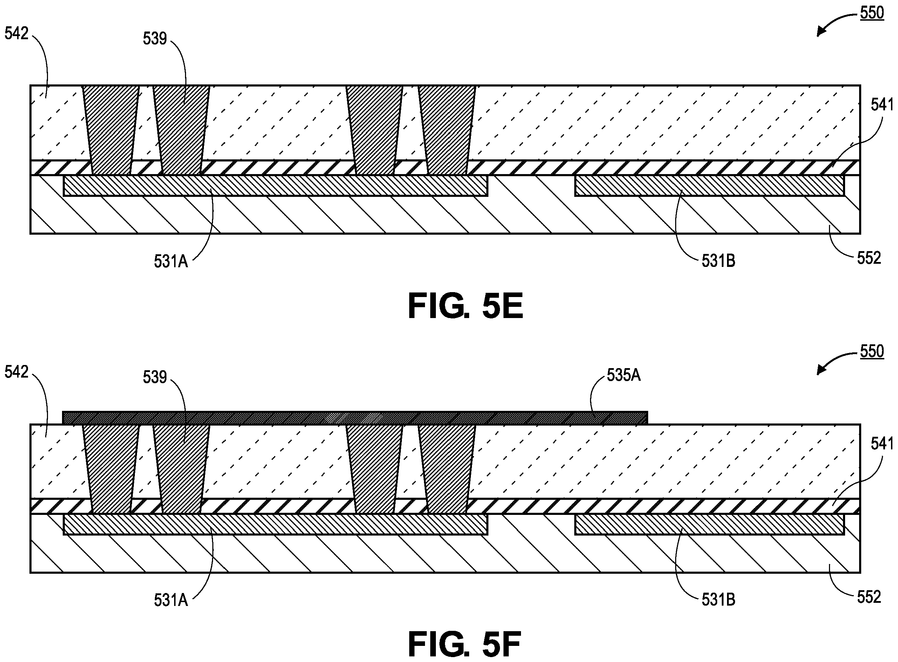

Referring now to Figure 5E, a cross-sectional illustration of the die 550 after vias 539 are deposited in the via openings 543 is shown, in accordance with an embodiment. In an embodiment, the vias 539 may comprise an electrically conductive material. For example, the vias 539 may comprise one or more of copper, an alloy including copper, aluminum, or any other metallic elements. In an embodiment, the vias 539 may be formed with any suitable deposition process, such as CVD, PVD, plating processes, or the like.

Referring now Figure 5F, a cross-sectional illustration of the die 550 after a first plate 535A is provided over the ILD 542 is shown, in accordance with an embodiment. In an embodiment, the first plate 535A may be an electrically conductive material, such as copper or the like. The first plate 535A may have a thickness that is less than the thickness of the first trace 531A. Though, the first plate 535A may also be the same thickness or thicker than the first trace 531A in some embodiments. The first plate 535A may be directly contacted by the vias 539. The vias 539 may provide electrical coupling between the first plate 535A and the first trace 531A.

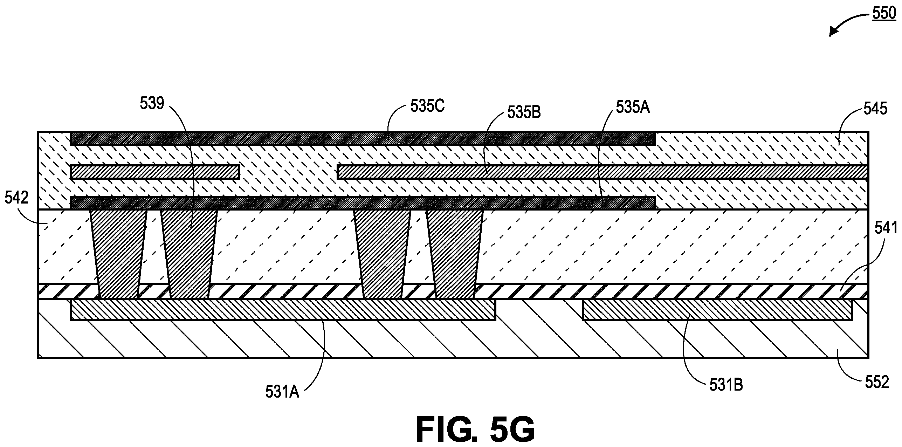

Referring now to Figure 5G, a cross-sectional illustration of the die 550 after additional plates 535 are fabricated is shown, in accordance with an embodiment. In an embodiment, two additional plates 535 (i.e., second plate 535B and third plate 535C) are formed in Figure 5G. In an embodiment, a high-k dielectric 545 may be provided between the plates 535. The plates 535 may be considered as being surrounded by or embedded within the high-k dielectric 545. The high-k dielectric 545 may be a material with a dielectric constant k that is equal to or greater than the k-value of SiO₂ (e.g., around 3.9 or higher). The plates 535 and the high-k dielectric 545 may be deposited with any suitable deposition processes.

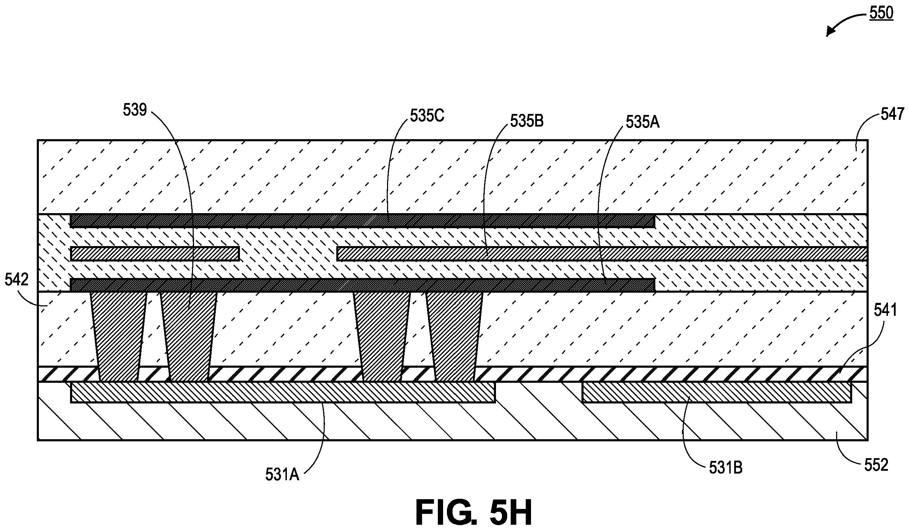

Referring now to Figure 5H, a cross-sectional illustration of the die 550 after a second ILD 547 is deposited over the high-k dielectric 545 is shown, in accordance with an embodiment. In an embodiment, the second ILD 547 may be similar or the same as the ILD 542. That is second ILD 547 may be similar in material composition to ILD 542. Though, ILD 542 and second ILD 547 may have different material compositions in some embodiments. The second ILD 547 may be deposited with any suitable process.

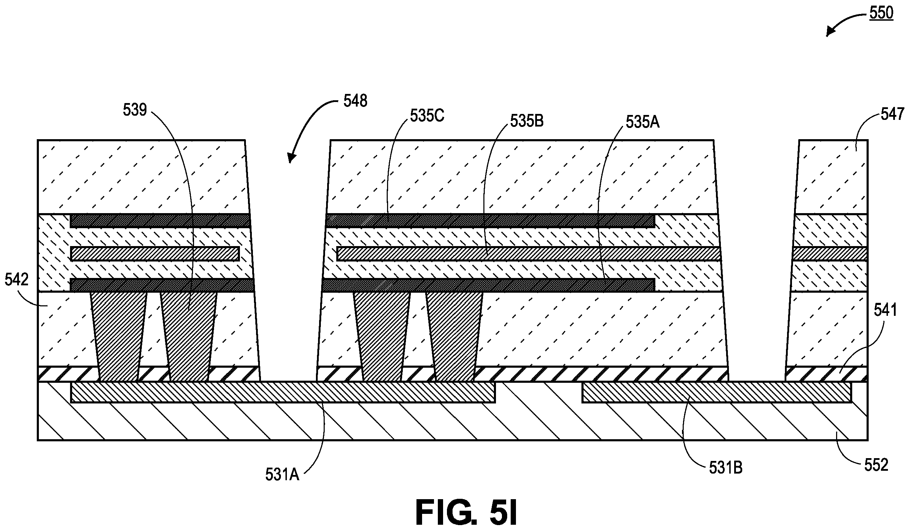

Referring now to Figure 5I, a cross-sectional illustration of the die 550 after via openings 548 are formed through the structure is shown, in accordance with an embodiment. In an embodiment, the via openings 548 may be formed with lithography and etching processes, or any other suitable subtractive process. The via openings 548 may extend from the top of the second ILD 547 down to the first metal layer 531. A first via openings 548 may expose the first trace 531A and a second via opening 548 may expose the second trace 531B. The first opening 548 intersects the first plate 535A and the third plate 535C, and the second opening 548 intersects the second plate 535B.

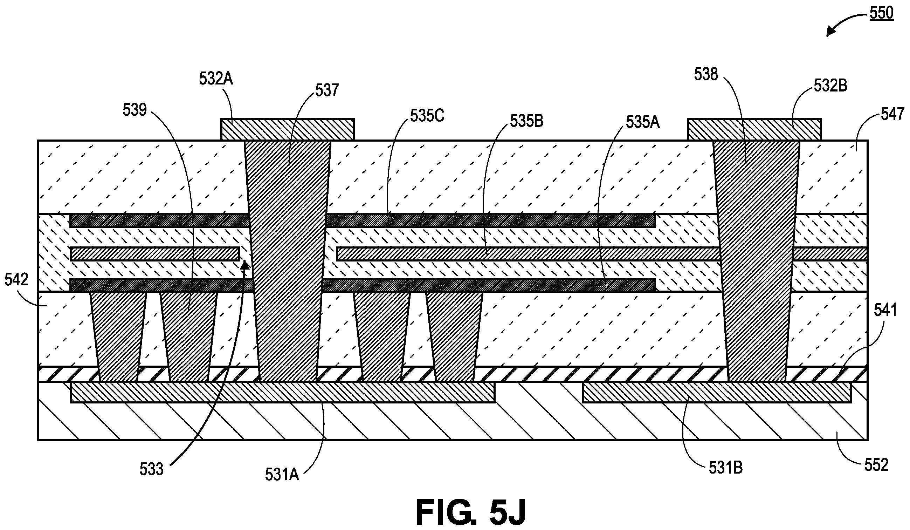

Referring now to Figure 5J, a cross-sectional illustration of the die 550 after the vias 537 and 538 are formed is shown, in accordance with an embodiment. In an embodiment, the vias 537 and 538 may be formed with any suitable material deposition process (e.g., CVD, PVD, etc.). The vias 537 and 538 may comprise electrically conductive materials such as copper or the like.

In an embodiment, a second metal layer 532 is formed over the vias 537 and 538. The second metal layer 532 may comprise a third trace 532A and a fourth trace 532B. The via 537 may electrically couple the first trace 531A to the third trace 532A, and the via 538 may electrically couple the second trace 531B to the fourth trace 532B. The via 537 may electrically couple the first plate 535A and the third plate 535C to the first trace 531A, and the via 538 may electrically couple the second plate 535B to the second trace 531B. The via 537 may pass through an opening 533 in the second plate 535B, and the via 537 is electrically isolated from the second plate 535B.

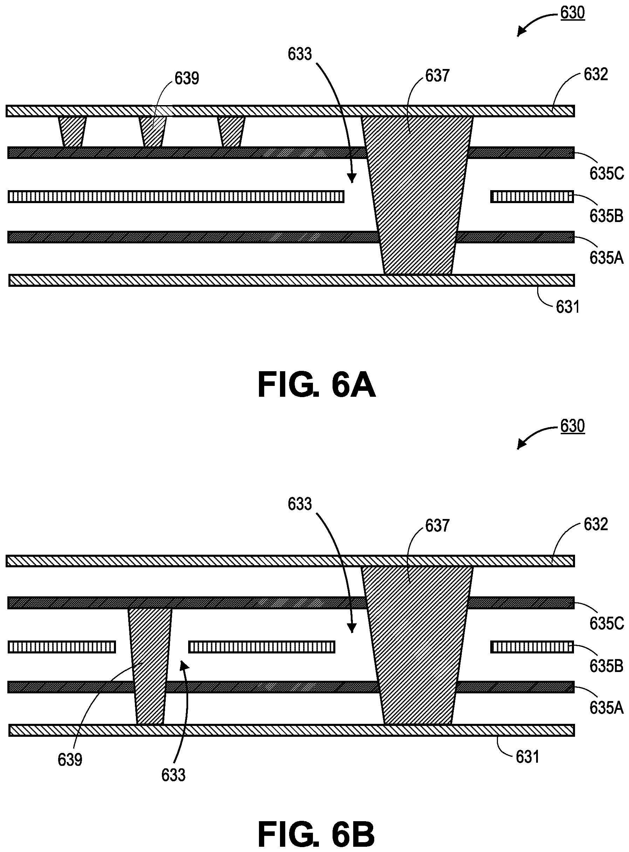

Referring now to Figures 6A - 7B a series of cross-sectional illustrations of capacitor structures 630 and 730 with alternative configurations that may also be used to reduce impedance is shown, in accordance with an embodiment.

Referring now to Figure 6A, a cross-sectional illustration of a capacitor structure 630 is shown, in accordance with an embodiment. The capacitor structure 630 may comprise a first metal layer 631 and a second metal layer 632. A stack of electrically conductive plates 635A, 635B, and 635C may be provided between the metal layers 631 and 632. In an embodiment, a via 637 electrically couples the first metal layer 631 to the second metal layer 632. The via 637 may contact the first plate 635A and the third plate 635C, and the via 637 may pass through an opening 633 in the second plate 635B. The second plate 635B may be contacted by a separate via (not shown) that is provided between the first metal layer 631 and the second metal layer 632.

In an embodiment, additional vias 639 may be provided between the third plate 635C and the second metal layer 632. While three vias 639 are shown, it is to be appreciated that any number of additional vias 639 may be used in some embodiments. The additional vias 639 provide lower impedance without needing to pass through any of the plates 635. As such, capacitance density is not negatively impacted.

Referring now to Figure 6B, a cross-sectional illustration of a capacitor structure 630 is shown, in accordance with an additional embodiment. The capacitor structure 630 may comprise a first metal layer 631 and a second metal layer 632. A stack of electrically conductive plates 635A, 635B, and 635C may be provided between the metal layers 631 and 632. In an embodiment, a via 637 electrically couples the first metal layer 631 to the second metal layer 632. The via 637 may contact the first plate 635A and the third plate 635C, and the via 637 may pass through an opening 633 in the second plate 635B. The second plate 635B may be contacted by a separate via (not shown) that is provided between the first metal layer 631 and the second metal layer 632.

In an embodiment, a second via 639 is provided between the third plate 635C and the first metal layer 631. The second via 639 provides an additional current path between the plates 635A and 635C and the first metal layer 631 in order to reduce impedance. In an embodiment, the second via 639 passes through an opening 633 in the second plate 635B. The presence of an additional opening 635B may reduce capacitance density with the benefit of there being a reduced impedance for the capacitor structure 630.

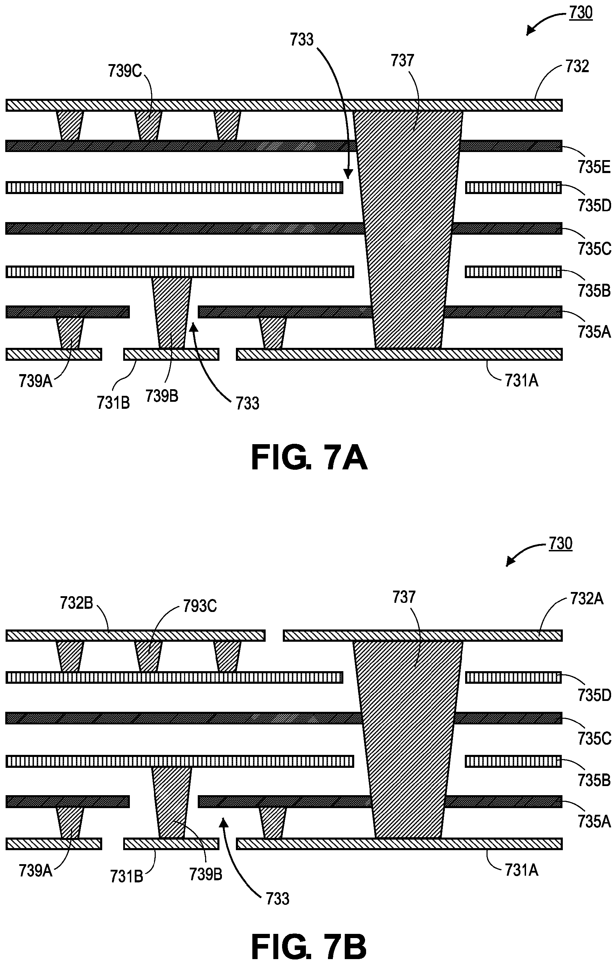

Referring now to Figure 7A, a cross-sectional illustration of a capacitor structure 730 is shown, in accordance with an embodiment. The capacitor structure 730 may comprise a first metal layer 731 and a second metal layer 732. A stack of electrically conductive plates 735 may be provided between the metal layers 731 and 732. For example, five plates 735A, 735B, 735C, 735D, and 735E are provided. In an embodiment, a via 737 may electrically couple the first metal layer 731 to the second metal layer 732. The via 737 may contact odd numbered plates 735A, 735C, and 735E, and the via 737 may pass through openings 733 in even numbered plates 735B and 735D.

In an embodiment, additional vias 739 may be provided in order to reduce impedance. For example, vias 739A may be provided between the first plate 735A and a first region 731A of the first metal layer 731. A via 739B may be provided between the second plate 735B and a second region 731B of the first metal layer 731. The via 739B may pass through an opening 733 in the first plate 735A. Additionally, vias 739C may be provided between the second metal layer 732 and the fifth plate 735E.

Referring now to Figure 7B, a cross-sectional illustration of a capacitor structure 730 is shown, in accordance with an additional embodiment. The capacitor structure 730 may comprise a first metal layer 731 (with a first region 731A and a second region 731B) and a second metal layer 732 (with a first region 732A and a second region 732B). A stack of electrically conductive plates 735 may be provided between the metal layers 731 and 732. For example, four plates 735A, 735B, 735C, and 735D are provided. In an embodiment, a via 737 may electrically couple the first region 731A of the first metal layer 731 to the first region 732A of the second metal layer 732. The via 737 may contact odd numbered plates 735A and 735C, and the via 737 may pass through openings 733 in even numbered plates 735B and 735D.

In an embodiment, additional vias 739 may be provided in order to reduce impedance. For example, vias 739A may be provided between the first plate 735A and a first region 731A of the first metal layer 731. A via 739B may be provided between the second plate 735B and a second region 731B of the first metal layer 731. The via 739B may pass through an opening 733 in the first plate 735A. Additionally, vias 739C may be provided between the second region 732B of the second metal layer 732 and the fourth plate 735D.

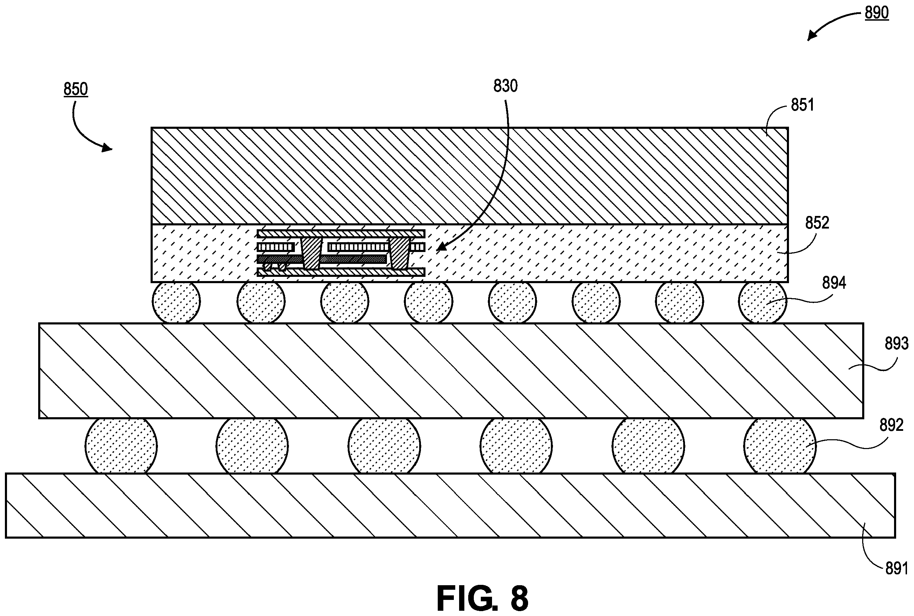

Referring now to Figure 8, a cross-sectional illustration of an electronic system 890 is shown, in accordance with an embodiment. In an embodiment, the electronic system 890 may comprise a board 891, such as a printed circuit board (PCB), a motherboard, or the like. The board 891 may be coupled to a package substrate 893 by interconnects 892. The interconnects 892 may be a second level interconnect (SLI) architecture, such as solder balls, sockets, or the like. In an embodiment, the package substrate 893 may be a coreless substrate or a cored substrate. In the case of a cored substrate, the core may be a solid glass core layer or an organic dielectric with (or without) glass fiber reinforcement.

In an embodiment, the package substrate 893 may be coupled to a die 850 by interconnects 894. The interconnects 894 may comprise a first level interconnect (FLI) architecture, such as solder balls, copper bumps, a hybrid bonding interface, or the like. In an embodiment, the die 850 may comprise a substrate 851, such as a semiconductor substrate. The die 850 may further comprise a BEOL stack 852. In an embodiment, a capacitor structure 830 may be provided in, or embedded in, the BEOL stack 852. The capacitor structure 830 may be similar to any of the capacitor structures described in greater detail herein. For example, the capacitor structure 830 may include additional vias in order to reduce impedance without negatively impacting capacitance density.

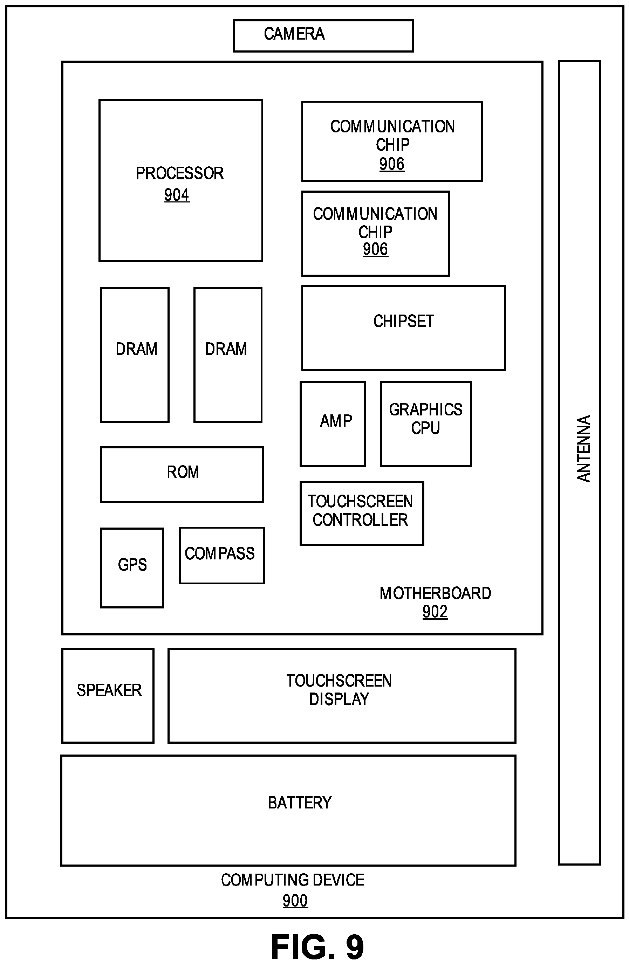

Figure 9 illustrates a computing device 900 in accordance with one implementation of the disclosure. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of the disclosure, the integrated circuit die of the processor may be part of an electronic package that includes a capacitor structure with an additional via between a metal layer and a capacitor plate to enable impedance reductions, in accordance with embodiments described herein. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In accordance with another implementation of the disclosure, the integrated circuit die of the communication chip may be part of an electronic package that includes a capacitor structure with an additional via between a metal layer and a capacitor plate to enable impedance reductions, in accordance with embodiments described herein.

In an embodiment, the computing device 900 may be part of any apparatus. For example, the computing device may be part of a personal computer, a server, a mobile device, a tablet, an automobile, or the like. That is, the computing device 900 is not limited to being used for any particular type of system, and the computing device 900 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus, comprising: a first metal layer; a first plate above the first metal layer, wherein the first plate is electrically conductive; a second plate above the first plate, wherein the second plate is electrically conductive; a third plate above the second plate, wherein the third plate is electrically conductive; a second metal layer above the third plate; a first via between the first metal layer and the second metal layer, wherein the first via contacts the first plate and the third plate; a second via between the first metal layer and the second metal layer, wherein the second via contacts the second plate; and a third via between the first metal layer and the first plate.

Example 2: the apparatus of Example 1, wherein: the first metal layer comprises a first trace and a second trace, wherein the first via contacts the first trace and the second via contacts the second trace; and the second metal layer comprises a third trace and a fourth trace, wherein the first via contacts the third trace and the second via contacts the fourth trace.

Example 3: the apparatus of Example 2, wherein the third via contacts the first trace.

Example 4: the apparatus of Examples 1-3, wherein the first via passes through an opening in the second plate.

Example 5: the apparatus of Examples 1-4, wherein the second via passes through a first opening in the first plate and a second opening in the second plate.

Example 6: the apparatus of Examples 1-5, wherein the third via passes through an opening in the second plate and contacts the third plate.

Example 7: the apparatus of Examples 1-6, further comprising: a fourth via between the first metal layer and the second plate, wherein the fourth via passes through an opening in the first plate.

Example 8: the apparatus of Examples 1-7, further comprising: a dielectric material between the first plate, the second plate, and the third plate, wherein the dielectric material has a dielectric constant of at least 3.9.

Example 9: the apparatus of Examples 1-8, further comprising: a fourth plate between the third plate and the second metal layer, wherein the fourth plate is electrically conductive.

Example 10: the apparatus of Example 9, wherein the second via contacts the fourth plate, and wherein the first via passes through an opening in the fourth plate.

Example 11: an apparatus, comprising: a substrate, wherein the substrate comprises a semiconductor material; and a dielectric layer with a capacitor structure over the substrate, wherein the capacitor structure comprises: a first metal layer and a second metal layer; a first plate, a second plate, and a third plate in a stack between the first metal layer and the second metal layer; a first via between the first metal layer and the second metal layer, wherein the first via contacts the first plate and the third plate, and wherein the first via passes through an opening in the second plate; and a second via between the first metal layer and the first plate.

Example 12: the apparatus of Example 11, wherein the capacitor structure further comprises: a third via between the first metal layer and the second metal layer, wherein the third via contacts the second plate, and wherein the third via passes through openings in the first plate and the third plate.

Example 13: the apparatus of Example 12, wherein the first via is electrically coupled to a first voltage source and the third via is electrically coupled to a second voltage source that is different than the first voltage source.

Example 14: the apparatus of Examples 11-13, wherein first metal layer comprises a trace, and wherein the first via and the second via both contact the trace.

Example 15: the apparatus of Examples 11-14, further comprising: a third via between the second metal layer and the third plate.

Example 16: the apparatus of Examples 11-15, further comprising: a third via between the second metal layer and the second plate, wherein the third via passes through an opening in the third plate.

Example 17: an apparatus, comprising: a board; a package substrate coupled to the board; and a die with a capacitor structure coupled to the package substrate, wherein the capacitor structure comprises: a stack of plates between a first metal layer and a second metal layer, wherein a first via contacts even number plates in the stack of plates and a second via contacts odd number plates in the stack of plates, and wherein a third via electrically couples the first metal layer to a bottommost plate in the stack of plates.

Example 18: the apparatus of Example 17, wherein the stack of plates comprises three or more plates.

Example 19: the apparatus of Example 17 or Example 18, wherein the capacitor structure further comprises: a dielectric material between the plates in the stack of plates, wherein the dielectric material has a dielectric constant that is at least 3.9.

Example 20: the apparatus of Examples 17-19, wherein the apparatus is part of a personal computer, a server, a mobile device, a tablet, or an automobile.

## Claims

1. An apparatus, comprising:
a first metal layer;
a first plate above the first metal layer, wherein the first plate is electrically conductive;
a second plate above the first plate, wherein the second plate is electrically conductive;
a third plate above the second plate, wherein the third plate is electrically conductive;
a second metal layer above the third plate;
a first via between the first metal layer and the second metal layer, wherein the first via contacts the first plate and the third plate;
a second via between the first metal layer and the second metal layer, wherein the second via contacts the second plate; and
a third via between the first metal layer and the first plate.

2. The apparatus of claim 1, wherein:
the first metal layer comprises a first trace and a second trace, wherein the first via contacts the first trace and the second via contacts the second trace; and
the second metal layer comprises a third trace and a fourth trace, wherein the first via contacts the third trace and the second via contacts the fourth trace.

3. The apparatus of claim 2, wherein the third via contacts the first trace.

4. The apparatus of claim 1, 2 or 3, wherein the first via passes through an opening in the second plate.

5. The apparatus of claim 1, 2 or 3, wherein the second via passes through a first opening in the first plate and a second opening in the second plate.

6. The apparatus of claim 1, 2 or 3, wherein the third via passes through an opening in the second plate and contacts the third plate.

7. The apparatus of claim 1, 2 or 3, further comprising:
a fourth via between the first metal layer and the second plate, wherein the fourth via passes through an opening in the first plate.

8. The apparatus of claim 1, 2 or 3, further comprising:
a dielectric material between the first plate, the second plate, and the third plate, wherein the dielectric material has a dielectric constant of at least 3.9.

9. The apparatus of claim 1, 2 or 3, further comprising:
a fourth plate between the third plate and the second metal layer, wherein the fourth plate is electrically conductive.

10. The apparatus of claim 9, wherein the second via contacts the fourth plate, and wherein the first via passes through an opening in the fourth plate.

11. A method, comprising:
forming a first metal layer;
forming a first plate above the first metal layer, wherein the first plate is electrically conductive;
forming a second plate above the first plate, wherein the second plate is electrically conductive;
forming a third plate above the second plate, wherein the third plate is electrically conductive;
forming a second metal layer above the third plate;
forming a first via between the first metal layer and the second metal layer, wherein the first via contacts the first plate and the third plate;
forming a second via between the first metal layer and the second metal layer, wherein the second via contacts the second plate; and
forming a third via between the first metal layer and the first plate.

12. The method of claim 11, wherein:
the first metal layer comprises a first trace and a second trace, wherein the first via contacts the first trace and the second via contacts the second trace; and
the second metal layer comprises a third trace and a fourth trace, wherein the first via contacts the third trace and the second via contacts the fourth trace.

13. The method of claim 12, wherein the third via contacts the first trace.

14. The method of claim 11, 12 or 13, wherein the first via passes through an opening in the second plate.

15. The method of claim 11, 12 or 13, wherein the second via passes through a first opening in the first plate and a second opening in the second plate.
